Europäisches Patentamt

European Patent Office

Office européen des brevets

(11) Publication number : **0 480 775 A2**

# (12) EUROPEAN PATENT APPLICATION

(21) Application number : 91309425.6

(22) Date of filing : 14.10.91

(51) Int. Cl.⁵ : **H01L 27/146, H04N 1/028**

(30) Priority : **12.10.90 JP 273527/90**
**26.11.90 JP 321839/90**

(43) Date of publication of application :
**15.04.92 Bulletin 92/16**

(84) Designated Contracting States :
**DE FR GB**

(71) Applicant : **SEIKO INSTRUMENTS INC.**
**31-1, Kameido 6-chome Koto-ku**
**Tokyo 136 (JP)**

(72) Inventor : **Kawahara, Yukito, c/o Seiko**
**Instruments Inc.**
**31-1, Kameido 6-chome**
**Koto-ku, Tokyo (JP)**

Inventor : **Machida, Satoshi, c/o Seiko**
**Instruments Inc.**
**31-1, Kameido 6-chome**
**Koto-ku, Tokyo (JP)**
Inventor : **Mukainakano, Hiroshi, c/o Seiko**
**Instruments Inc.**
**31-1, Kameido 6-chome**
**Koto-ku, Tokyo (JP)**
Inventor : **Yokomichi, Masahiro, c/o Seiko**
**Instruments Inc.**
**31-1, Kameido 6-chome**
**Koto-ku, Tokyo (JP)**
Inventor : **Higashi, Masato, c/o Seiko**
**Instruments Inc.**
**31-1, Kameido 6-chome**
**Koto-ku, Tokyo (JP)**

(74) Representative : **Sturt, Clifford Mark et al**
**J. MILLER & CO. Lincoln House 296-302 High**
**Holborn**
**London WC1V 7JH (GB)**

(54) **An image sensor and a method of inspecting image sensors.**

(57)    Image sensors (10, 50) are used in optical reading apparatus and have hitherto had poor photo response uniformity from the individual photo-sensing elements (3, 43).

The present invention improves the photo response uniformity by adding an additional layer (5) which is opaque to radiation but has uniform windows (42) for each of the photo sensing elements (3, 43).

Whilst manufacturing such image sensors (10, 50) there has also been difficulties in obtaining accurate characteristics of the individual image sensors (10,50) when the image sensors are still connected together on the wafer (41). The present invention improves the accuracy of the testing results by cutting grooves (52) in the boundaries (44) between adjacent image sensors prior to being tested.

Image sensors described above may be employed in an image sensor head (80).

FIG. 1(d)

The present invention relates to image sensors and in particular, but not exclusively, to linear image sensors which are installed in facsimile apparatus, image scanners, digital copiers etc., for reading text and diagrams. The present invention also relates to a method of inspecting image sensors which are formed in an array on a semiconductor wafer and in particular, but not exclusively, to contact type linear image sensors which are used in image readers such as facsimile apparatus, image scanners for desk top publishing apparatus, digital copiers and bar code readers.

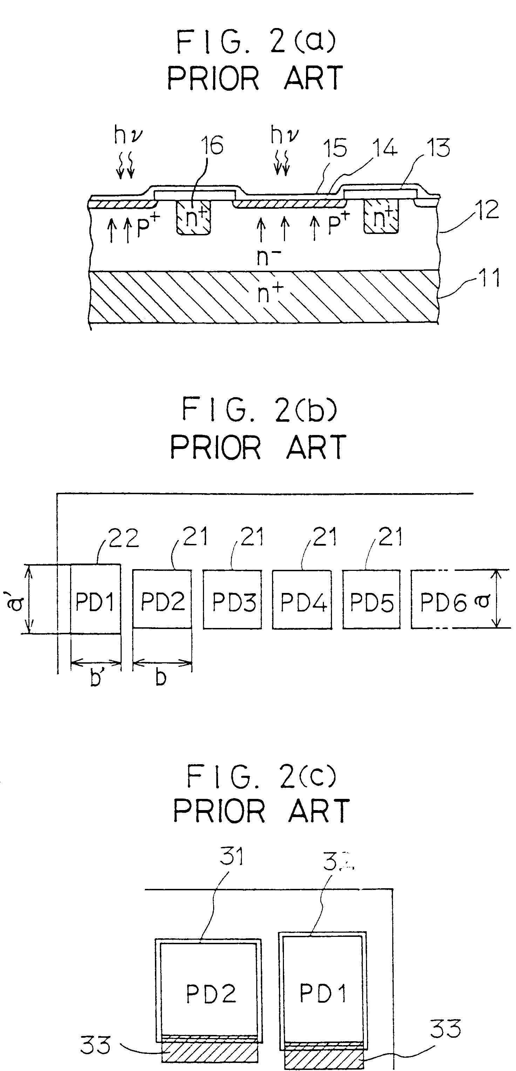

Part of a conventional linear image sensor is shown in figure 2(a) - (c). Figure 2(a) is a crow section of a photo diode light receiving element, a linear array of which comprises a linear image sensor. The linear image sensor is formed on an n type semiconductor substrate (11) on which is disposed an n type impurity layer (12). Each element is formed by a p type high impurity concentration diffusion layer (14). Each element is surrounded by an isolation layer (16) of an n type impurity diffusion. An inter-insulating field (13) of silicon dioxide is deposited on the surface of the substrate so as to deactivate it. The elements are thus arranged to receive light radiation hν falling on the diffusion layers (14).

As shown in figure 2(b) the linear image sensor comprises photo-sensing elements (21) all of which are the same size. At the end positions of the linear image sensor, the photo-sensing element (22) has a different size from the other photosensing elements (21). However, the surface area of photo-sensing elements (22) are equal to the surface area of each of the internal photo-sensing elements (21). That is to say a x b = a′x b′.

The photo-sensing elements (22) which are at the end positions of the image sensor have a different shape to the other photo-sensing elements (21) due to the way in which the image sensor is manufactured. That is to say, a plurality of image sensors are manufactured together on one wafer and are connected linearly to form one long linear sensor. The linear image sensors are then defined by a dicing process which separates each of the image sensors. Often, the end position of the image sensor is partially destroyed by the dicing process and the width of the partially destroyed portion may vary from a few μm to 30 μm. Damage to the end photosensing element leads to instability of the p-n diffusion junction. However, it is not possible to have only a few μm between the photo-sensing element (22) and the end position of the image sensor and the photo-sensing element (21) adjacent thereto because of interference. Thus, in order to maintain the same space between each of the photosensing elements, the photo-sensing elements (22) which are at the end positions of the image sensor have a rectangular shape which is narrower than the other photo-sensing elements (21). Furthermore, it is important to maintain the same surface area for each of the photo-sensing elements (21), (22) and so the photo-sensing elements (22) at the end positions of the image sensor are deeper than the other photo-sensing elements (21). As shown in figure 2(c) each of the photo-sensing elements (31, 32) are coupled to an electrode (33).

An example of such conventional linear image sensors can be found in Japanese patent publication no. 57-157680. A description of the manner in which the linear image sensors operate is as follows.

Each of the photo-sensing elements are receptive to light radiation hν to store photo-excited carriers. Regionally generated photo-sensing carriers in the photo-sensing elements (21,22) are the same in number. However, the distance travelled for the photo-excited carriers stored in the photo-sensing element (22, 32) is longer than for those photo-excited carriers stored in the internal photo-sensing elements (21, 31). Consequently, the field intensity of photo-sensing elements (21, 22) is different. The consequence of this leads to a difference in reading time between photo-sensing elements (21, 22) which has been found to cause a problem.

This problem has been reduced by employing photo-sensing elements each comprising a photo diode which helps to reduce the difference in reading time but this is still not satisfactory. The problem is even more pronounced when the photosensing elements comprise photo-transistors. In this case, the amplification factor Hfe of the photo-sensing element (22) is significantly higher than that of the photo-sensing element (21) such that the output signal of the photo-sensing element (22) is larger than that of the photo-sensing element (21). In both cases, the problem results in a lack of photo response uniformity of the linear image sensor.

For good resolution and quality of images, the photo-sensing elements are preferably made so as to have the same size and arranged equi-distantly from each other. Thus in order to maintain high resolution and quality of image, the surface areas of the elements must be made the same and arranged equi-distant from each other. But this has meant in the past that there is a lack of photo response uniformity from linear image sensors.

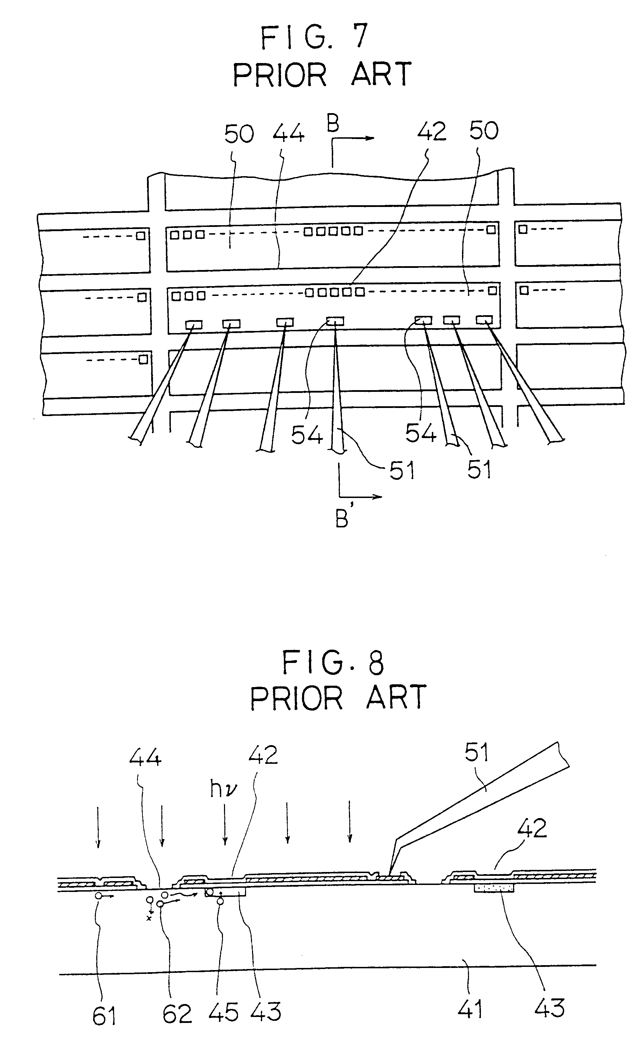

As discussed above, a plurality of linear image sensors are formed at the same time on the surface of the semiconductor surface by conventional fabrication techniques to produce solid state imaging devices. Figure 7 illustrates part of a semiconductor wafer having a plurality of linear image sensors separated by boundaries (44) and each of the image sensors comprises a linear array of photo sensitive elements (42). Prior to isolating individual image sensors (50), the photo electric conversion characteristics of each of the image sensors are inspected by irradiating the surface of the semiconductor wafer.

Figure 8 illustrates a sectional view of a number of image sensors (50) being inspected by an inspection needle (51) which irradiates the surface of the semiconductor wafer. As the inspection needle passes over the semiconductor wafer, the boundaries (44) are also irradiated. Photo-sensing carriers(62) are thus generated in the boundaries (44) and may be able to penetrate a diffusion layer (43) forming the photo-sensing element (42) which is part of the image sensor (50) being inspected. The detected photo-electric conversion efficiency of the image sensor (50) is thus increased.

In the worst case, since linear image sensors (50) are adjacent to one another whilst being inspected, photo-sensing carriers (61) are generated in adjacent linear image sensors and enter the diffusion layer (43) which further increases the photo-electric conversion efficiency of the particular linear image sensor being inspected.

This detected photo-electric conversion efficiency is particularly not comparable with the actual photo-electric conversion efficiency when the inspected linear image sensors are used in the form of multi chip and contact type linear image sensors which are eventually separated to form individual linear image sensors. In isolation, the actual photo-electric conversion characteristics of the image sensor are significantly less than the detected photo-electric conversion efficiency because photo-sensing carriers (45) are only generated by light being irradiated through the photo-sensing lens (42).

In the worst case, the actual photo-conversion efficiency of an image sensor can be 20 to 60 per cent lower than the detected photo-electric conversion efficiency when the image sensor is inspected whilst in contact with other linear image sensors.

One aim of the present invention is therefore to provide an image sensor which has improved photo response uniformity.

A further aim of the present invention is to provide a method of inspecting image sensors to improve the accuracy of obtaining the photo-electric efficiency of an image sensor.

According to the present invention there is provided an image sensor comprising:

a semiconductor substrate of a first conductivity type;

two or more photo-sensing elements disposed on said substrate each comprising an impurity diffusion layer having a second conductivity type; characterised by

each impurity diffusion layer having the same shape and size; and by

a layer which is opaque to radiation disposed on said photo-sensing elements having two or more windows each of which overlaps with a respective photo-sensing element such that each window exposes the same surface area of impurity diffusion layer thereby improving photo response uniformity.

The uniform shape of the diffusion layers and the windows in the opaque layer provide a uniform surface area for the photo-sensing element exposed to the radiation irrespective of whether the photo-sensing element is at the end position of an image sensor and consequently the above problem is thereby obviated. Preferably the opaque layer is a metallic thin film. The number of photo excited carriers of each of the photo-sensing elements is thus approximately equal. Furthermore, the insulation capacity between the impurity diffusion layers and the opaque metallic thin film layer is approximately equal. This leads to the output impedance and common-emitter current gain hfe from each of the photo-sensing elements when converting the light received to an output signal to be approximately uniform.

Also according to the present invention there is provided a method of inspecting an image sensor formed on a surface of a semiconductor wafer, characterised by:

cutting grooves at the boundaries between the image sensor under inspection and adjacent image sensors formed on the surface of the semiconductor wafer, and

irradiating the semiconductor wafer to determine the photo-electric conversion efficiency of the image sensor under inspection.

The introduction of grooves at the boundaries between each of the image sensors prevents the photo excited carriers generated at the boundaries from moving to the diffusion layers of the image sensors. This is because most of the photo excited carriers are caught in the vicinity of the grooves and most of them in the boundary region or lower region recombine. Consequently, few photo excited carriers enter the photo-sensing element to be inspected from the boundaries. Thus the detected photo electric conversion efficiency of any image sensor is more accurate.

According to the present invention there is also provided a method of manufacturing image sensors comprising;

forming two or more image sensors on a semiconductor wafer; characterised by

cutting grooves at the boundaries between each of the image sensors;

irradiating the semiconductor wafer to determine the photo electric conversion efficiency of one of more the image sensors; and

cutting the wafer at the boundaries so as to separate the image sensors

Also according to the present invention there is provided an image sensor head comprising;

a base plate;

one or more semiconductor substrates of a first conductivity type on each of which is disposed two or more photo-sensing elements arrayed linearly in a main scanning direction, each photo-sensing element comprising an impurity diffusion layer having a second conductivity type; characterised by

a layer which is a opaque to radiation disposed on each of said photosensing elements having two or more windows, each of which overlaps with a respective photo-sensing element and each of which has the same shape thereby improving the photo response uniformity of the image sensor head.

Embodiments of the present invention will now be described by way of example with reference to the accompanying drawings, of which:

Figs. 1(a) and (b) respectively are sectional views of photo sensing elements according to a preferred embodiment of the present invention, taken along line X1 - X2 and Y1 - Y2 of Fig. 1(c);

Fig. 1(c) is a plan view of an end portion of an image sensor according to the preferred embodiment;

Fig. 1(d) is a plan view of an end portion of an image sensor with the photosensing windows overlapping with the photo-sensing elements;

Figs. 1(e) and (f) are respectively sectional views of an end portion of an image sensor, taken in the direction of the arrows substantially along line X1'- X2'and Y1'Y2'of Fig. 1(c);

Fig. 2(a) is a sectional view of conventional photo-sensing element;

Figs. 2(b) and (c) are respectively plan views of an end portion of a conventional linear image sensor;

Fig. 3 is a sectional view, taken along line X - Y of Fig. 4 at the time of cutting grooves on a semiconductor wafer before inspection of the linear image sensors according to the preferred embodiment,

Fig. 4 is a plan view showing the semiconductor wafer after cutting grooves at the boundaries between the linear image sensors;

Fig. 5 is a plan view at the time of inspecting the linear image sensors;

Fig. 6 is a sectional view taken along the line A - A' of Fig. 5;

Fig. 7 is a plan view at the time of inspecting by a conventional method;

Fig. 8 is a sectional view of Fig. 7 taken along the line B - B'; and

Fig. 9 is a plan view of image sensor head according to the preferred embodiment.

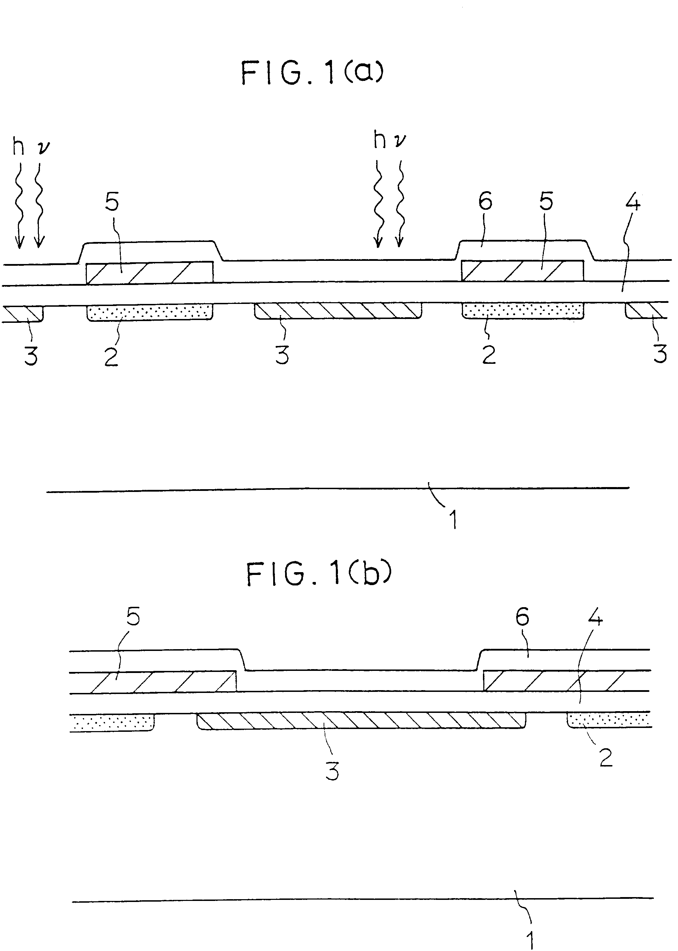

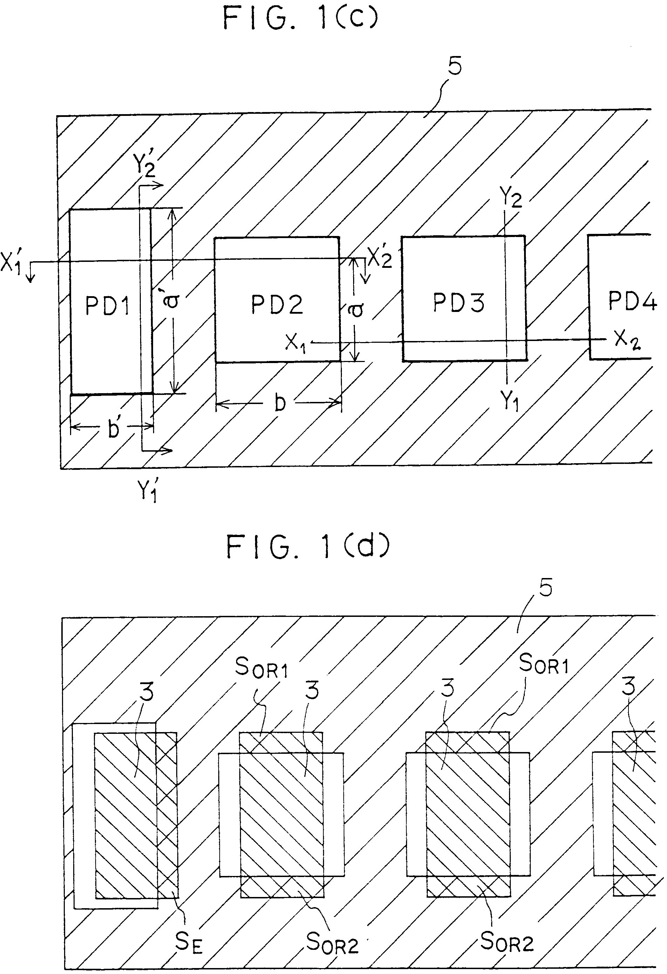

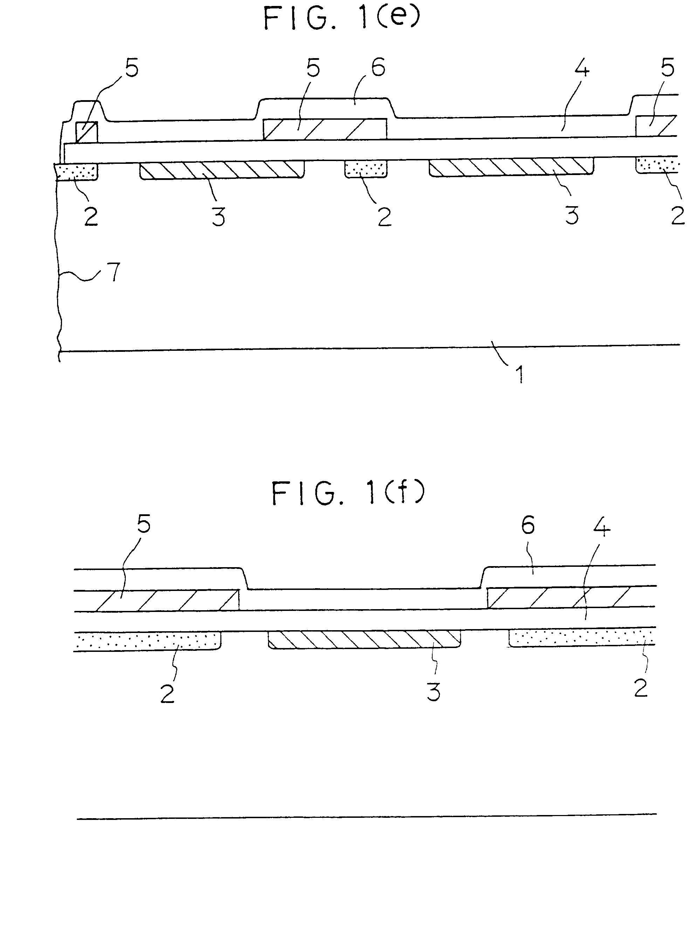

With reference to Fig. 1, an image sensor comprises a number of photo-sensing elements arranged on the surface of a semiconductor substrate (1). The semiconductor substrate (1) comprises silicon and is of an n type conductivity. The photo-sensing elements are formed by an impurity diffusion layer (3) which has a p type conductivity. This impurity diffusion layer (3) may be formed from high density Boron B or Indium In. The layer (3) effectively stores the positive charge left by the photo excited carriers generated by the substrate (10) on radiation $h\nu$.

Each of the photo-sensing elements is surrounded by an isolation layer (2). The isolation layer (2) is of an n type conductivity and may be formed from doping with phosphorus P, arsenic As or antimony Sb. The surface of the substrate (1) is then covered by an inter-insulating film (4) over and above the aforementioned layer. This inter-insulating film (4) needs to be transparent and usually comprising silicon dioxide. The film (4) may be formed by thermal oxidation or chemical vapour deposition and so on.

A film (5) is then disposed on the inter-insulating film (4) which is opaque to radiation. In the film (5) there are formed one or more windows each of which correspond to a respective photo sensing element (3). Consequently the film (5) shades the semiconductor substrate and determines the areas of the semiconductor substrate which may be irradiated. This shading film (5) may be formed from a metallic film comprising alluminium Al. The shading film (5) may be formed by depositing the metal through sputtering or vaccum evaporation which is then etched and patterned.

A further layer is then deposited on the semicondutor substrate. This layer comprises of a passivation film (6) consisting of transparent phosphrous silicate glass PSG or silicon nitride $Si_3N_4$. The passivation film (6) protects the semicondutor substrate (1) from ion impurities or moisture.

The photo-sensing elements (3) are arranged linearly and become the detecting portion of a linear image sensor. In Figure 1(c) $PD_1$, $PD_2$. etc., are windows in the non transmittable metallic thin film (5). Each of the internal windows $PD_2$, $PD_3$ ...$PD_{n-1}$ where there are n photo-sensing elements in the image sensor have the same shape and surface area. That is to say each has a surface area SPD = a x b. At the end portion of the image sensor the windows, i.e., $PD_1$ and $PD_n$ have the same area but have a different shape from the other windows. That is to say the surface area SPD'= a'x b' and SPD'= SPD. However, the photo sensing elements all have the same shape and surface area.

As shown in Figure 1(d), the non transmittable metallic thin film (5) overlaps the diffusion layer (3) of each photo-sensing element. The areas of the diffusion layer of the internal photo-sensing elements which are covered by the non transmittable metallic thin film (5) are referenced $S_{or1}S_{or2}$. These overlapped portions $S_{or1}S_{or2}$ generate an insulative capacity COR.

Those photo-sensing elements positioned at the end portions of the image sensor have an overlap portion $S_E$. The areas of overlap of the photo-sensing elements at these end portions are the same as the overlapped portions of the internal photosensing elements. That is to say $S_E = S_{or1} + S_{or2}$. Although the overlap portions are different in shape they are equal in area and consequently the insulation capacity CE of the overlap portions of the photo-sensitive elements at the end portions of the image sensor are equal to the insulation capacity COR of the overlap portions of the internal photo-sensing elements. The output impedance and common emmitter current gain hfe for the end positioned photo-sensing elements and other photosensing elements when reading text are approximately uniform. The reading time is also approximately the same. This leads to enhanced photo response uniformity.

When the photo-sensing elements comprise photo transistors, the common emitter current gain hfe becomes uniform by making each form of impurity diffusion layer equal. The photo response uniformity of the photo transistor type linear image sensors is then more uniform. Furthermore the photo response uniformity from photo transistor type image sensors is more than for photo diode type image sensors.

The preferred embodiment of the present invention thus enables the generated photo excited carriers which are stored to be the same in each photo sensing element. Thus, each photo sensing element reads at the same rate. This thus improves the photo response conversion efficiency. Consequently, in spite of the photo sensing element positioned at the end portions being of a different shape due to the limitations in the mounting operation, the photo response from these photo sensing elements do not differ from the other photo sensing elements. Poor quality of images from these end positioned photo sensing elements is thus obviated.

Furthermore, the windows can be positioned equi-distantly along the image sensor yet allowing the photo sensing element at the end position to be disposed closer to its adjacent photo sensing element. Thus when separating the image sensors the damage caused by cutting the semiconductor substrate can be minimised since the photo sensing elements will not be positioned close to the edge of the image sensor. This also improves the photo response conversion efficiency. There will be some generated photo excited carriers that will be destroyed in the dicing process but of a relatively small number and which will not effect greatly the photo response uniformity achieved by the preferred embodiment.

Hereinafter, a method of inspecting such linear image sensors according to the preferred embodiment will now be described.

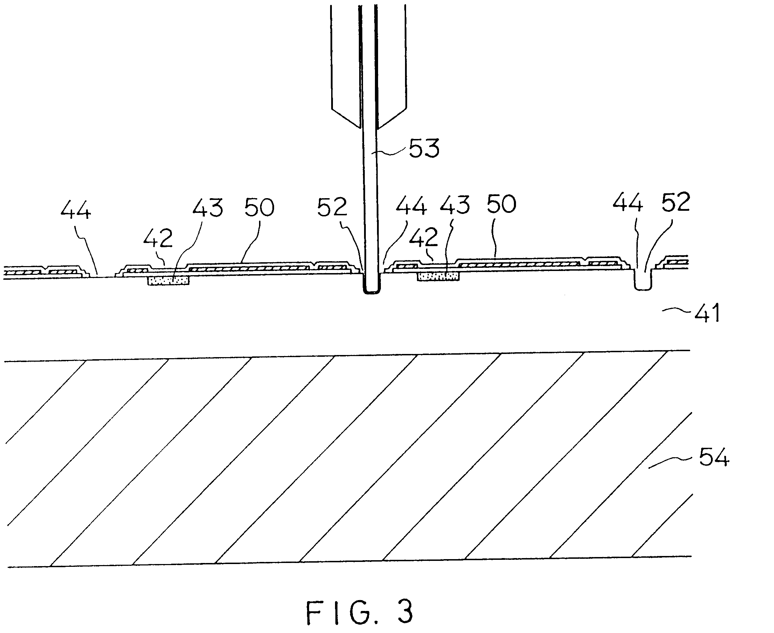

In figure 3 there is shown a cross section of the semiconductor wafer (41) placed on a dicing saw stage (54). The semiconductor wafer (41) has a number of image sensors (50) with a boundary (44) between adjacent image sensors. A dicing saw blade (53) cuts grooves into the semicondutor wafer (41) at the boundaries (44). It has been found by the inventors that the optimum depth for cutting the grooves is in the order of 10 µm or deeper. This is because light is absorbed by the semiconductor wafer within a depth of 10 µm. Furthermore, the distance between the grooves (52) and the diffusion layer (43) on the linear image sensor (50) is preferably at least 5 µm. These dimensions are chosen to minimise photo sensing carriers stored in the diffusion layers (43) from translocating to other image sensors due to the distortion on the surface of the semicondutor wafer (41).

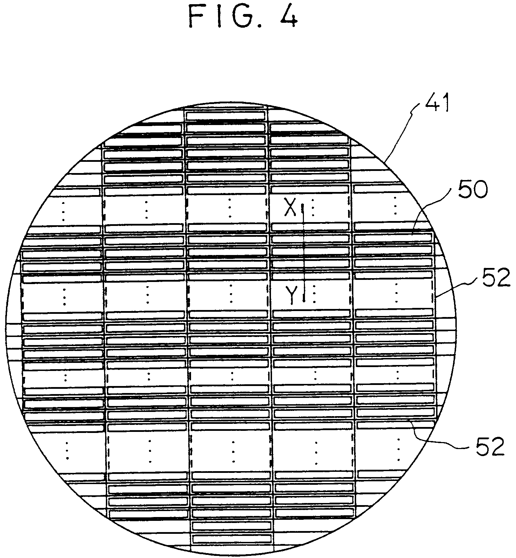

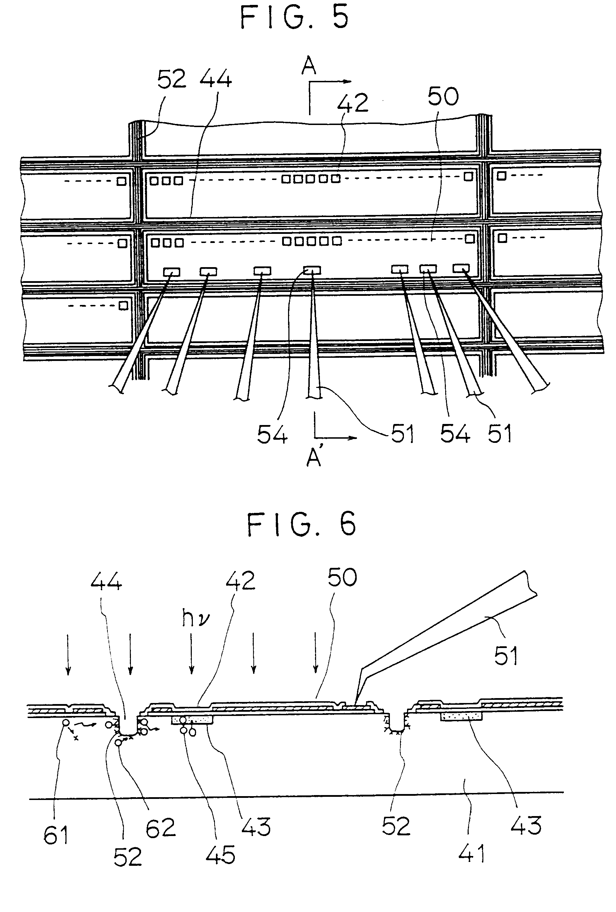

Figure 4 illustrates a semiconductor wafer having grooves (52) cut into each boundary (44) between the linear image sensors (50). Each of the linear image sensors are then inspected using a solid state imaging device tester which is usually an inspection needle (51). Please refer to figures 5 & 6. The inspection needle (51) probes each of the linear image sensors (50) to test if it functions normally. During inspection, not only the linear image sensor being inspected is irradiated but also adjacent areas are irradiated. However, most of the photo sensing carriers (62) generated by radiation in the boundary region (44) are caught or recombined in the region of deformed lattice of distorted region created by the grooves (52). Furthermore, those photo sensing carriers (61) generated around the linear image sensors (50) being inspected, are diffused or recombined remotely and at a large depth from the surface of the semiconductor wafer (41) or are diffused to the grooves (52) then recombined. Consequently, most of the photo sensing carriers stored in the diffusion layer (43) are photo sensing carriers (45) generating by the irradiation of light hv through the photo sensing window (42) of the particular linear image sensor (50) being inspected.

This method of inspecting a linear image sensor enables a more accurate photo electric conversion characteristic to be assessed when the linear image sensors are still connnected together on the semiconductor wafer prior to being separated. Although the method is simple, it is highly effective.

When manufacturing a multi chip and contact type image sensors comprising linear image sensors which are inspected by the above method, capabilities such as sensitivity of individual image sensor can be determined more accurately in advance. This then enables constants of field circuits to be set more accurately. This obviously increases the speed of fabricating such multi chip and contact type image sensors. Moreover, photo sensing elements with the same degree of sensivity can be can be collected together at this stage.

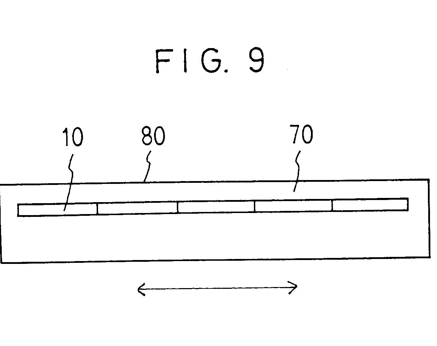

An image sensor where the structure described above may be used in an image sensor head as shown in figure 9. The image sensor head (80) comprises a base plate (70) with a plurality of image sensors (10) mounted on the base plate (70) in a linear arrangement with respect to the main scanning direction. Adjacent image sensors (10) are disposed closely with a gap of less than several 10 µm. Such an image sensor head of the contact type have a uniform output performance which has not been known hitherto yet with an extremely simple construction.

Various aspects of the preferred embodiment of the present invention have been described above. However, it will be appreciated by a person skilled in the art that modifications may be made without departing from the scope of the present invention. For example, when inspecting a linear image sensor, the grooves cut between adjacent image sensors may be formed by a scraper or a laser. Alternatively, a plasma etcher may be used to form the grooves during the ordinary semiconductor fabrication process.

## Claims

1. An image sensor (10, 50) comprising:
   a semiconductor substrate (1, 11) of a first conductivity type;
   two or more photo-sensing elements (3, 43) disposed on said substrate, each comprising an impurity diffusion layer (3, 43) having a second conductivity type; characterised by
   each impurity diffusion layer having the same shape and size; and by a layer (5) which is opaque to radiation disposed on said photo-sensing elements having two or more windows (42) each of which overlaps with a respective photo-sensing element such that each window exposes the same surface area of impurity diffusion layer thereby improving photo response uniformity.

2. An image sensor as claimed in claim 1, in which said layer (5) comprises a metal.

3. An image sensor as claimed in claim 2, in which said layer (5) comprise alluminium.

4. An image sensor as claimed in any one of claims 1 to 3, in which the surface area of overlap between each of the windows and the respective photo-sensing element is the same.

5. A method inspecting an image sensor (10, 50) formed on a surface of a semiconductor wafer (41), characterised by:
   cutting grooves (52) at the boundaries (44) between the image sensor under inspection and adjacent image sensors formed on the surface of the semiconductor wafer, and
   irradiating the semiconductor water to determine the photo-electric conversion efficiency of the image sensor under inspection.

6. A method of manufacturing image sensors (10, 50) comprising;
   forming two or more image sensors on a semiconductor wafer (41); characterised by
   cutting grooves (52) at the boundaries (44) between each of the image sensors; irradiating the semiconductor wafer to determine the photo electric conversion efficiency of one of more the image sensors; and
   cutting the wafer at the boundaries so as to separate the image sensors.

7. An image sensor head comprising;
   a base plate (80);
   one or more semiconductor substrates (70) of a first conductivity type on each of which is disposed two or more photo-sensing elements (3, 43) arrayed linearly in a main scanning direction, each photo-sensing element comprising an impurity diffusion layer (3, 43) having a second conductivity type; characterised by
   each impurity diffusion layer having the same shape and size; and by
   a layer (5) which is a opaque to radiation disposed on each of said photo-sensing elements having two or more windows (42), each of which overlaps with a respective photo-sensing element such that each window exposes the same surface area of impurity diffusion layer thereby improving the photo response uniformity of the image sensor head.

# FIG. 1(a)

hν       hν

5       6   5    4

3    2     3      2      3

1

# FIG. 1(b)

5        6   4

3       2

1

# FIG. 1(c)

# FIG. 1(d)

FIG. 1(e)

FIG. 1(f)

# FIG. 2(a)
## PRIOR ART

hν    16    hν    15    14    13

$n^+$    $P^+$    $n^-$    $P^+$    $n^+$    12

$n^+$    11

# FIG. 2(b)
## PRIOR ART

22    21    21    21    21

a'    PD1 | PD2 | PD3 | PD4 | PD5 | PD6    a

b'    b

# FIG. 2(c)
## PRIOR ART

31    32

PD2    PD1

33    33

10

FIG. 3

# FIG. 4

# FIG. 5

# FIG. 6

# FIG. 7
## PRIOR ART

50  44  B  42  50

54  54

51  51

B'

# FIG. 8
## PRIOR ART

44  42  51

hν  42

61  62  45  43  41  43

# F I G. 9